# EUROPEAN PATENT SPECIFICATION

(11) **EP 2 869 338 B1**
(45) Date of publication and mention of the grant of the patent: **25.09.2019**
(21) Application number: 12869590.5
(22) Date of filing: 14.12.2012
(51) Int. Cl.: H01L 27/146, H01L 27/02

(54) **ESD PROTECTING SYSTEM AND X RAY FLAT PLATE DETECTOR**
ESD-SCHUTZSYSTEM UND FLACHER RÖNTGENSTRAHLENDETEKTOR
SYSTÈME PARASURTENSEUR ET RADIOMÈTRE À PLAQUE PLANE

(30) Priority: 29.06.2012 CN 201210225073
(43) Date of publication of application: 06.05.2015
(73) Proprietor: Shanghai Tianma Micro-Electronics Co., Ltd., 201201 Shanghai (CN)
(72) Inventor: HUANG, Zhongshou, Shanghai 201201 (CN); XIA, Jun, Shanghai 201201 (CN); XIAO, Wenwen, Shanghai 201201 (CN); JIN, Libo, Shanghai 201201 (CN)
(74) Representative: Maiwald Patent- und Rechtsanwaltsgesellschaft mbH
(86) International application number: PCT/CN2012/086618
(87) International publication number: WO 2014/000394

(56) References cited:
- CN-A- 101 986 430
- CN-A- 102 097 059
- CN-A- 102 244 082
- US-A1- 2006 279 667
- US-A1- 2009 084 938
- US-B1- 6 323 490

## Description

### FIELD OF THE INVENTION

The invention relates to an ESD protection system, and particularly to an ESD protection system for protecting an X-ray flat panel detector. Further, the invention relates to an X-ray flat panel detector with an ESD protection system.

### BACKGROUND OF THE INVENTION

Presently, there are two types of X-ray flat panel detectors in internal and external markets: one is of an indirect energy conversion type, and the other is of a direct energy conversion type. Due to its advantages such as high conversion efficiency, wide dynamic range, high spatial resolution, and enhanced environmental adaptability, the indirect energy conversion type of X-ray flat panel detector has become the most popular detector in the X-ray flat panel detector market.

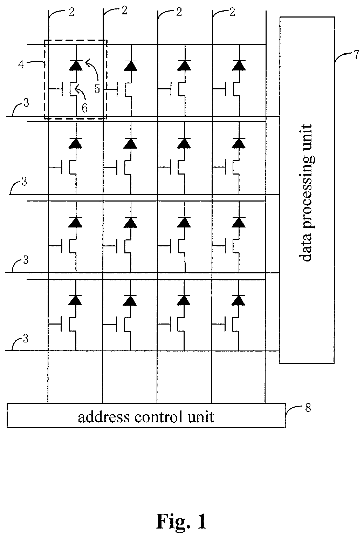

As shown in Figure 1, the indirect energy conversion type of X-ray flat panel detector (referred to as an X-ray flat panel detector for short in the invention) includes multiple scan lines (can also be referred to as gate lines) 2 and multiple data lines 3 which are formed on a substrate (not shown), the scan lines 2 and the data lines 3 being arranged in an intersecting manner to form multiple pixel regions, and a pixel unit 4 being provided in each of pixel regions; and a flicker layer or a phosphor layer (not shown) formed on the substrate and covering the pixel region. Each pixel unit 4 includes a photodiode 5 and a pixel switch 6 having a terminal thereof connected to the photodiode 5. The photodiode 5 is adapted to convert the visible light into charges. The photodiode 5 is generally formed of amorphous silicon, because the amorphous silicon and its alloy (such as amorphous silicon doped with germanium) have perfect photo-electric conversion function in the wavelength of visible light, has better anti-radiation performance for the radiation with high energy, and can be fabricated in large scale. The pixel switch 6 is adapted to control the pixel unit 4 to be switched on or off, which may be an amorphous silicon thin film transistor (amorphous silicon thin film transistor) or a diode. The pixel switches 6 in each row of pixel units 4 are connected to the same data line 3. The pixel switches 6 in each column of pixel units 4 are connected to the same corresponding scan line 2. The data lines 3 are connected to a data processing unit (can also be referred to as a readout unit) 7, and the scan lines 2 are connected to an address control unit (can also be referred to as a gate drive unit) 8.

The working principle of the above X-ray flat panel detector is as follow. An X-ray generates the visible light after passing through the flicker layer or the phosphor layer, the visible light is converted into the charges by the photodiode 5 of the pixel unit 4, the charges are stored in the photodiode 5, the address control unit 8 applies a line-by-line voltage on the scan lines 2 in the pixel array 1, so that the pixel switches 6 are switched on line-by-line, the charges stored in the photodiode 5 are output to the data processing unit 7 via the data lines 3, the data processing unit 7 further performs processes, such as an enlargement and an analogy to digital conversion, on the obtained electrical signal, and thus image information is obtained finally.

Because the thin films in the photodiode and the TFT (i.e., the pixel switch) in the X-ray flat panel detector are too many and have large area, electro-static discharge (ESD) is prone to occur during the process of designing, fabricating, assembling and testing of the X-ray flat panel detector. Nearly all of the microelectronic circuits will be very sensitive to the ESD, and thus electro-static protection must be provided for the X-ray flat panel detector, for improving its yield and reducing its production cost.

The ESD protection system of the existing X-ray flat panel detector includes a shorting bus and a metal-insulator-metal diode (MIM diode). However, these ESD protection systems have many problems, such as incompatibility with the testing and maintaining requirements of the X-ray flat panel detector.

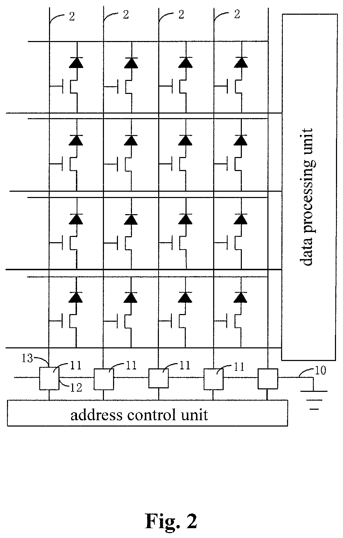

To solve the above problems, as shown in Figure 1, an ESD protection system for providing an ESD protection for an X-ray flat panel detector is disclosed in a US patent publication No. US2006/0092591A1 published on May 4, 2006 and titled "on-substrate ESD protection for array based image sensors". As shown in Figure 2, the ESD protection system includes an ESD leakage bus 10 formed on a substrate (not shown) and an ESD protection circuit 11 formed on the substrate, where the ESD leakage bus may be grounded. The ESD protection circuit 11 has a first wiring terminal 12 connected to the ESD leakage bus 10 and a second wiring terminal 13 connected to the scan line 2 of the X-ray flat panel detector.

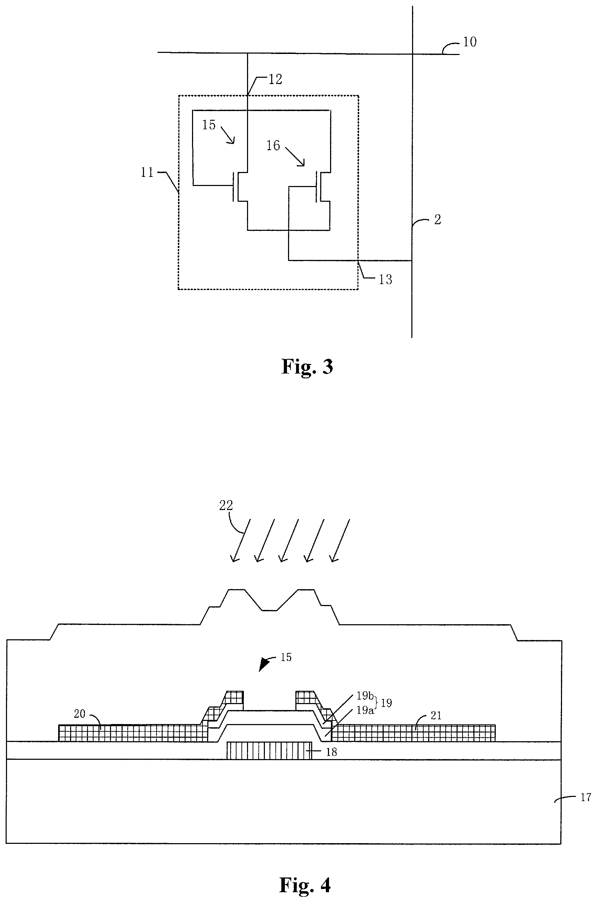

Figure 3 is a schematic diagram of an equivalent circuit of the ESD protection system in Figure 2. As shown in Figure 3, the ESD protection circuit 11 includes a pair of amorphous silicon thin film transistors, i.e., a first amorphous silicon thin film transistor 15 and a second amorphous silicon thin film transistor 16, connected in a back-to-back manner. When ESD occurs on the scan line 2 of the X-ray flat panel detector, in the case that the voltage between the first wiring terminal 12 and the second wiring terminal 13 of the ESD protection circuit is two times larger than the threshold voltage of the thin film transistor, the first amorphous silicon thin film transistor 15 and the second amorphous silicon thin film transistor 16 in the ESD protection system will be switched on automatically, so as to ensure that the ESD can flow from the scan line 2 into the ESD leakage bus 10 in a short time, and thus prevent a part of the detector from being broken-down by the ESD voltage or prevent a generation of a TFT threshold voltage drift or other damages.

Figure 4 is a sectional view of the first amorphous silicon thin film transistor in the above ESD protection circuit. As shown in Figure 4, the first amorphous silicon thin film transistor 15 is formed on the substrate 17, the transistor 15 includes the gate 18, an active layer 19 located above the gate 18, and the source 20 and the drain 21 located above the active layer 19, in which the active layer 19 includes an amorphous silicon layer 19a and a N⁺ amorphous silicon layer 19b located above the a-Si layer 19a. As shown in Figure 3, in the ESD protection circuit 11, the second amorphous silicon thin film transistor 16 has the same structure as that of the first amorphous silicon thin film transistor 15.

As shown in Figure 3 and Figure 4, it can be seen from the working principle of the X-ray flat panel detector that in the normal use of the X-ray flat panel detector, the X-ray will irradiate the flicker layer or the phosphor layer above the pixel unit, and then be converted into visible light by the flicker layer or the phosphor layer. Because the pixel unit and the ESD protection circuit of the X-ray flat panel detector are formed on the same substrate, the visible light will radiate the ESD protection circuit while radiating the pixel unit. It means that the first amorphous silicon thin film transistor 15 and the second amorphous silicon thin film transistor 16 in the ESD protection circuit will also be exposed to the visible light 22. However, because the channels of the first amorphous silicon thin film transistor 15 and the second amorphous silicon thin film transistor 16 include amorphous silicon which can convert the visible light into charges, large photocurrent will occur in the ESD protection circuit during the working process of the X-ray flat panel detector.

Since the ESD protection circuit is connected to the scan line of the X-ray flat panel detector, the photocurrent will affect the voltage on the scan line, so that an actual voltage value on the scan line will be deviated from an ideal voltage value. It will result in the fluctuation of the finally obtained electronic image (horizontal and vertical stripes will occur in the image), and an increased noise. In order to make the voltage on the scan line meet the requirements, the voltage on the scan line may be corrected or compensated by an external circuit of the X-ray flat panel detector, which will cause a waste of driving power consumption.

Further, if the pixel switch of the pixel unit is the amorphous silicon thin film transistor, the amorphous silicon thin film transistor of the ESD protection circuit and the amorphous silicon thin film transistor of the pixel unit are formed in the same fabricating step, and thus the two thin film transistors have the same threshold voltage. In order to reduce the driving power consumption of the thin film transistor of the pixel unit, and to ensure that the thin film transistor of the ESD protection circuit may be switched on under a relatively low ESD voltage, the thin film transistor of the ESD protection circuit and the thin film transistor of the pixel unit generally have a threshold voltage between 1V and 3V. However, when the X-ray flat panel detector is driven to work normally, the voltage applied on the scan line is normally between -10V and +25V. Because the ESD protection circuit is connected to the scan line of the X-ray flat panel detector, the voltage applied on the thin film transistor of the ESD protection circuit is also between -10V and +25V. Then, a large leakage current will occur in the ESD protection circuit, no matter the voltage applied on the scan line is a positive voltage or a negative voltage, which will result in a large leakage current on the scan line and cause a great waste of driving power consumption. Therefore, in the X-ray flat panel detector with the above ESD protection system, it can not be achieved that the ESD protection circuit has small threshold voltage while a great waste of driving power consumption in the X-ray flat panel detector is avoided.

US 2009/084938 A1 provides a sensor panel and an image detecting device that can suppress generation of artifacts and an increase in noise. A sensor panel has an image detecting region formed from plural image sensor portions, data lines reading signals out from the image sensor portions, bidirectional diodes disposed at a peripheral edge of the image detecting region and connected to the data lines, and, at an upper layer of the bidirectional diodes, a semiconductor film that generates charges due to irradiation of electromagnetic waves. At the sensor panel, shield electrodes, that are connected to a common line, are disposed between the bidirectional diodes and the semiconductor film.

US 6323490 B1 provides an X-ray semiconductor detector having a pixel array structure in which a plurality of pixel elements are arrayed in a matrix. Each pixel element includes an X-ray/charge conversion film for generating charges in accordance with an incident X-ray, a storage capacitor for storing the signal charges generated in the X-ray/charge conversion film, a signal read transistor for reading the signal charges from the storage capacitor, and a protective diode arranged to remove excessive charges from the storage capacitor and prevent dielectric breakdown of the signal read transistor. The protective diode is arranged below the storage capacitor. Since the protective diode is arranged below the storage capacitor, it does not decrease the pixel density. Since the protective diode is covered with the storage capacitor, it can be shielded from an X-ray. Therefore, variations in OFF current of the protective diode by an X-ray and dielectric breakdown of the protective diode can be prevented.

CN 101986430 A provides an active matrix substrate including: a substrate; a display section having a pixel circuit formed on the substrate; and a protection circuit connected to an interconnection of the display section. The protection circuit has a diode-connected transistor, an insulating layer provided so as to cover the transistor, and a light-shielding layer provided in a region above the insulating layer so as to face at least a channel region in the transistor and electrically connected to at least any one of a gate electrode and a source electrode of the transistor.

### SUMMARY OF THE INVENTION

A problem to be solved by the invention is to provide an ESD protection system, which, when applied to an X-ray flat panel detector, not only can provide an ESD protection for the X-ray flat panel detector but also can avoid a photocurrent during the use of the X-ray flat panel detector, so as to reduce the effect of the photocurrent on the voltage of the scan line, and reduce an electronic image fluctuation, a noise and a waste of driving power consumption.

Another problem to be solved by the invention is to provide an X-ray flat panel detector with the above ESD protection system, for ensuring that the ESD protection circuit has small threshold voltage while reducing the leakage current in the ESD protection circuit, and thus avoiding the waste of driving power consumption in the X-ray flat panel detector.

To solve the above problems, an ESD protection system is provided according to the invention, as defined by claim 1.

Optionally, the ESD protection circuit may include a plurality of pairs of amorphous silicon thin film transistors which are connected in series, in parallel, or in series-parallel.

Optionally, an area of the first shading layer may be greater than or equal to that of the channel of the first amorphous silicon thin film transistor and that of the channel of the second amorphous silicon thin film transistor.

Optionally, the ESD leakage bus may be grounded or be connected to a first fixed potential.

Optionally, the second fixed potential may be provided by an external power supply.

Acording to the invention, the ESD protection circuit further includes a first conductive layer provided above the channel of the first amorphous silicon thin film transistor and the channel of the second amorphous silicon thin film transistor and being contacted with the first shading layer, wherein the first conductive layer may be provided above or under the first shading layer and at least overlaps with a part of the first shading layer, the first shading layer is formed of non-conductive material, and the first conductive layer is connected to a second fixed potential.

According to the invention, the second fixed potential is a negative fixed potential.

Optionally, the second fixed potential may be provided by an external power supply.

Accordingly, an X-ray flat panel detector is further provided according to the invention, and the X-ray flat panel detector includes:
a plurality of scan lines and a plurality of data lines formed on a substrate, wherein the plurality of scan lines and the plurality of data lines are arranged in an intersecting manner to form a plurality of pixel regions, and a pixel unit including a photosensitive unit and a pixel switch is provided in each of the plurality of pixel regions; and
the ESD protection system described above, wherein the number of the ESD protection circuit in the ESD protection system is one or more, and at least one of the plurality of scan lines is connected to the second wiring terminal of one of the ESD protection circuits.

Optionally, the photosensitive unit may be a photodiode, the pixel switch is an amorphous silicon thin film transistor, the photodiode may include a lower electrode, a photoelectric conversion layer provided on the lower electrode and an upper electrode provided on the photoelectric conversion layer, the lower electrode of the photodiode may be connected to the pixel switch, the upper electrode of the photodiode may be connected to a second conductive layer which is externally biased, and the pixel switch may include the source connected to the lower electrode of the photosensitive unit, the drain connected to one of the data line and the gate connected to one of the scan line.

Optionally, a second shading layer may be provided over the channel of the pixel switch.

Optionally, the second shading layer may at least overlap with a part of the second conductive layer and be contacted with the second conductive layer, and the second shading layer may be provided above or under the second conductive layer.

Optionally, the number of the ESD protection circuit in the ESD protection system may be two or more, the first wiring terminal of one of the ESD protection circuits may be connected to the ESD leakage bus, and the second wiring terminal of the one of the ESD protection circuits may be connected to one of the plurality of scan lines, and wherein the first wiring terminal of another of the ESD protection circuits may be connected to the ESD leakage bus, and the second wiring terminal of the another of the ESD protection circuits may be grounded.

Accordingly, another X-ray flat panel detector is further provided according to the invention, and the X-ray flat panel detector includes:
a plurality of scan lines and a plurality of data lines formed on a substrate, wherein the plurality of scan lines and the plurality of data lines are arranged in an intersecting manner to form a plurality of pixel regions, a pixel unit including a photosensitive unit and a pixel switch is provided in each of the plurality of pixel regions, the photosensitive unit is a photodiode, the pixel switch is an amorphous silicon thin film transistor, the photodiode includes a lower electrode, a photoelectric conversion layer provided on the lower electrode and an upper electrode provided on the photoelectric conversion layer, the lower electrode of the photodiode is connected to the pixel switch, the upper electrode of the photodiode is connected to a second conductive layer which is externally biased, and the pixel switch includes the source connected to the lower electrode of the photosensitive unit, the drain connected to one of the data lines and the gate connected to one of the scan lines; and
the ESD protection system described above, wherein the number of the ESD protection circuit is one or more, and at least one of the plurality of scan lines is connected to the second wiring terminal of one of the ESD protection circuits, the second fixed potential is a negative fixed potential, the second conductive layer which is externally biased is connected to the first conductive layer of the ESD protection circuit to provide the second fixed potential, or the ESD leakage bus is connected to the first conductive layer of the ESD protection circuit to provide the second fixed potential.

Accordingly, yet another X-ray flat panel detector is further provided according to the invention, and the X-ray flat panel detector includes:
a plurality of scan lines and a plurality of data lines formed on a substrate, wherein the plurality of scan lines and the plurality of data lines are arranged in an intersecting manner to form a plurality of pixel regions, a pixel unit including a photosensitive unit and a pixel switch is provided in each of the plurality of pixel regions, the photosensitive unit is a photodiode, the pixel switch is an amorphous silicon thin film transistor, the photodiode includes a lower electrode, a photoelectric conversion layer provided on the lower electrode and an upper electrode provided on the photoelectric conversion layer, the lower electrode of the photodiode is connected to the pixel switch, the upper electrode of the photodiode is connected to a second conductive layer which is externally biased, and the pixel switch includes the source connected to the lower electrode of the photosensitive unit, the drain connected to one of the data lines and the gate connected to one of the scan lines; and
the ESD protection system described above, wherein the number of the ESD protection circuit is one or more, and at least one of the plurality of scan lines is connected to the second wiring terminal of one of the ESD protection circuits, the second fixed potential is a negative fixed potential, and the ESD leakage bus is connected to the first shading layer of the ESD protection circuit to provide the second fixed potential.

As compared with the prior art, the invention has the following advantages.

The ESD protection system according to the invention includes an ESD leakage bus and an ESD protection circuit, the ESD protection circuit has a first wiring terminal connected to the ESD leakage bus and a second wiring terminal, the ESD protection circuit includes at least a pair of amorphous silicon thin film transistors, the pair of amorphous silicon thin film transistors includes a first amorphous silicon thin film transistor and a second amorphous silicon thin film transistor connected in a back-to-back manner, and a first shading layer is provided over a channel of the first amorphous silicon thin film transistor and a channel of the second amorphous silicon thin film transistor. This ESD protection system, when applied to an X-ray flat panel detector, not only can provide ESD protection for the X-ray flat panel detector, but also can prevent the photocurrent from occurring during the use of the X-ray flat panel detector. Thus, the effect of the photocurrent on the voltage on the scan line is reduced, and the electronic image fluctuation, the noise and the waste of driving power consumption are reduced.

Further, when the first shading layer in the ESD protection system is connected to a fixed potential, it can be ensured that the ESD protection circuit has relatively small threshold voltage while the leakage current in the ESD protection circuit is restrained, and thus a great waste of driving power consumption in the X-ray flat panel detector is avoided.

Further, all the parts of the ESD protection system except the shading layer are formed during the existing fabrication process of the X-ray flat panel detector, thus nearly no new fabrication process is added.

### BRIEF DESCRIPTION OF THE DRAWINGS

Figure 1 is a schematic diagram of an equivalent circuit of a pixel array of an existing X-ray flat panel detector;
Figure 2 is a schematic diagram of an equivalent circuit of an X-ray flat panel detector with an ESD protection system, where the ESD protection system includes an ESD leakage bus and an ESD protection circuit, and the ESD protection circuit includes a first amorphous silicon thin film transistor and a second amorphous silicon thin film transistor;
Figure 3 is a schematic diagram of an equivalent circuit of the ESD protection system in Figure 2;
Figure 4 is a sectional view of the first amorphous silicon thin film transistor of the ESD protection system in Figure 2;
Figure 5 is a schematic diagram of an equivalent circuit of an ESD protection system in an embodiment of an ESD protection system according to the invention;
Figure 6 is a sectional view of a first amorphous silicon thin film transistor in an embodiment of a first amorphous silicon thin film transistor of the ESD protection system in Figure 5;
Figure 7 is a schematic diagram of an equivalent circuit of an X-ray flat panel detector in an embodiment of an X-ray flat panel detector with an ESD protection system according to the invention;
Figure 8 is an amplified view of the ESD protection circuit connected between the scan line and the ESD leakage bus in Figure 7;
Figure 9 is a sectional view of a pixel unit in an embodiment of an X-ray flat panel detector according to the invention;
Figure 10 is a structural diagram of an arrangement in which the first amorphous silicon thin film transistor and the second amorphous silicon thin film transistor are connected between the ESD leakage bus and the scan line;
Figure 11 is a first structural diagram of the arrangement in Figure 10 in which a first shading layer and a first conductive layer are provided above a channel of the first amorphous silicon thin film transistor and a channel of the second amorphous silicon thin film transistor;
Figure 12 is a second structural diagram of the arrangement in Figure 10 in which a first shading layer and a first conductive layer are provided above a channel of the first amorphous silicon thin film transistor and a channel of the second amorphous silicon thin film transistor;
Figure 13 is a third structural diagram of the arrangement in Figure 10 in which a first shading layer and a first conductive layer are provided above a channel of the first amorphous silicon thin film transistor and a channel of the second amorphous silicon thin film transistor;
Figure 14 is a graph of relation between an input voltage V_{bias} and a leakage current I_{esd} of the ESD protection circuit, in the case that a first shading layer connected to a negative fixed potential is provided on the ESD protection circuit and a first shading layer connected to a zero potential is provided on the ESD protection circuit respectively;
Figure 15 is a schematic diagram of an equivalent circuit for providing a negative fixed potential for the first shading layer of the ESD protection system according to the invention; and
Figure 16 is a schematic diagram of another equivalent circuit for providing a negative fixed potential for the first shading layer of the ESD protection system according to the invention.

### DETAILED DESCRIPTION OF THE INVENTION

A problem to be solved by the invention is to provide an ESD protection system, which, when applied to an X-ray flat panel detector, not only can provide ESD protection for the X-ray flat panel detector but also can prevent photocurrent from occurring during the use of the X-ray flat panel detector, for reducing the effect of the photocurrent on the voltage of the scan line, and thus reducing the electronic image fluctuation, the noise and the waste of driving power consumption.

To solve this problem, the ESD protection system according to the invention includes an ESD leakage bus and an ESD protection circuit, the ESD protection circuit has a first wiring terminal and a second wiring terminal, the ESD protection circuit includes at least a pair of amorphous silicon thin film transistors (a-Si TFTs), where the ESD protection circuit includes a first amorphous silicon thin film transistor and a second amorphous silicon thin film transistor connected in a back-to-back manner, the first wiring terminal of the ESD protection circuit is connected to the ESD leakage bus, and the ESD leakage bus is grounded or connected to a first fixed potential. When the ESD protection system is applied to an X-ray flat panel detector, at least one scan line is connected to the second wiring terminal of the ESD protection circuit. The ESD leakage bus is grounded or connected to a first fixed potential, and thus when ESD occurs on the scan line, the first amorphous silicon thin film transistor and the second amorphous silicon thin film transistor in the ESD protection circuit which are connected to this scan line are on, so that the ESD flows to the ESD leakage bus quickly and be conducted away.

In order to make sure that no photocurrent will occur in the ESD protection circuit during the use of the X-ray flat panel detector, the inventor proposes to provide a first shading layer formed of material with low light transmittance, the first shading layer is provided over the channel of the first amorphous silicon thin film transistor and the channel of the second amorphous silicon thin film transistor, for preventing the light from radiating to the channels of the first amorphous silicon thin film transistor and the second amorphous silicon thin film transistor, and thus avoiding the photocurrent.

In the case that the first shading layer is electrically floating, some uncontrolled effects will be introduced for the ESD protection system and the X-ray flat panel detector with the variation of the adopted process and environmental condition, so that the electrical properties of the ESD protection system and the X-ray flat panel detector may be affected. For example, the electrically floating first shading layer may affect the properties of the circuit, such as RC delay property and capacitive coupling property; and further, the electrically floating first shading layer may result in an unstable potential of the circuit, which will result in that the channels of the first amorphous silicon thin film transistor and the second amorphous silicon thin film transistor under the first shading layer can not be switched on or off normally, so that the ESD protection system can not work normally. In view of this, the inventor proposes to connect the first shading layer to a fixed potential, for preventing the above defects from occurring.

Another problem to be solved by the invention is to provide an X-ray flat panel detector with the above ESD protection system, for ensuring that the ESD protection circuit has small threshold voltage while reducing the leakage current in the ESD protection circuit, so as to avoid a great waste of driving power consumption in the X-ray flat panel detector.

To solve this problem, the inventor proposes to connect the first shading layer in the ESD protection system to a negative fixed potential. In this way, a small threshold voltage of the ESD protection circuit is ensured, and when the X-ray flat panel detector is driven to work normally, an electric field may be applied to the TFT from the back of the channels of the first amorphous silicon thin film transistor and the second amorphous silicon thin film transistor, so as to reduce the leakage current in the ESD protection circuit, and reduce the waste of driving power consumption in the X-ray flat panel detector.

It can be seen that if a first shading layer is provided over the channels of the first amorphous silicon thin film transistor and the second amorphous silicon thin film transistor of the ESD protection circuit, and the first shading layer is connected to a negative fixed potential, the above problems both can be solved.

Hereinafter, the technical solution in the embodiment of the present invention will be described clearly and completely by using an embodiment in conjunction with the drawings in the embodiment of the present invention. Obviously, the described embodiments are only a part of the embodiments of the present invention, but not all the embodiments. All the other embodiments obtained by those skilled in the art based on these embodiments without inventive efforts will fall within the scope of protection of the invention.

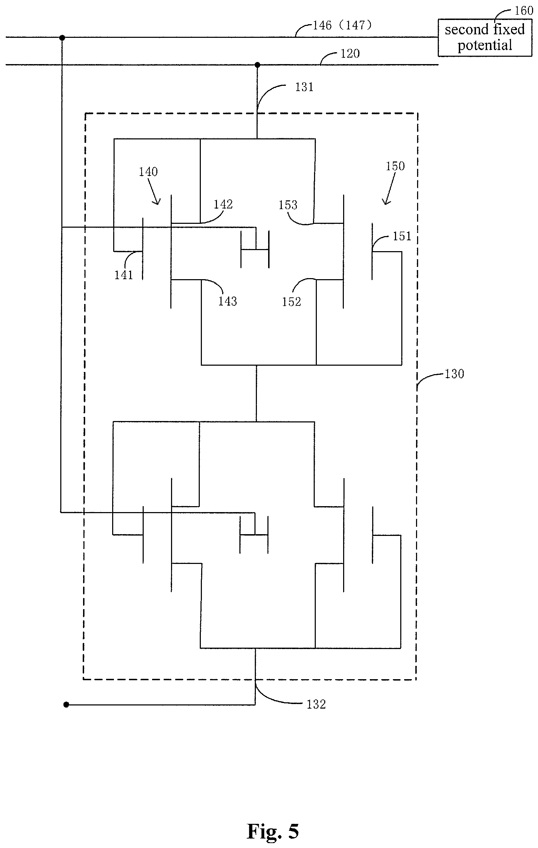

Figure 5 is a schematic diagram of an equivalent circuit of an ESD protection system in an embodiment of an ESD protection system according to the invention. As shown in Figure 5, the ESD protection system includes an ESD leakage bus 120 formed on a substrate (not shown); and an ESD protection circuit 130 formed on the substrate, in which the ESD protection circuit 130 has a first wiring terminal 131 connected to the ESD leakage bus 120 and a second wiring terminal 132 connected to the circuit for which the ESD protection is to be provided, and the number of the ESD protection circuit 130 may be one or more, which may be determined according to the application of the ESD protection system, for providing the optimal ESD protection for the circuit for which the ESD protection is to be provided.

The ESD protection circuit 130 includes at least a pair of amorphous silicon thin film transistors (a-Si TFTs). Specifically, the pair of amorphous silicon thin film transistors including a first amorphous silicon thin film transistor 140 and a second amorphous silicon thin film transistor 150 connected in a back-to-back manner. The so-called back-to-back manner is that the gate 141 and the source 142 of the first amorphous silicon thin film transistor 140 are connected to the drain 153 of the second amorphous silicon thin film transistor 150, and the drain 143 of the first amorphous silicon thin film transistor 140 is connected to the gate 151 and the source 152 of the second amorphous silicon thin film transistor 150. The connection terminal among the gate 141 and the source 142 of the first amorphous silicon thin film transistor 140 and the drain 153 of the second amorphous silicon thin film transistor 150 serves as a first wiring terminal 131 of the ESD protection circuit 130, and the connection terminal among the drain 143 of the first amorphous silicon thin film transistor 140 and the gate 151 and the source 152 of the second amorphous silicon thin film transistor 150 serves as a second wiring terminal 132 of the ESD protection circuit 130. Thus, the gate 141 and the source 142 of the first amorphous silicon thin film transistor 140 and the drain 153 of the second amorphous silicon thin film transistor 150 are connected to the ESD leakage bus 120, and the drain 143 of the first amorphous silicon thin film transistor 140 and the gate 151 and the source 152 of the second amorphous silicon thin film transistor 150 are connected to the circuit for which the ESD protection is to be provided.

In a preferred embodiment of the invention, the ESD protection circuit 130 includes multiple (two or more) pairs of amorphous silicon thin film transistors (including the first amorphous silicon thin film transistor 140 and the second amorphous silicon thin film transistor 150) which may be connected in series, in parallel or in series-parallel. If the multiple pairs of amorphous silicon thin film transistors are connected in series, the ESD protection system may endure higher ESD voltage; and if the multiple pairs of amorphous silicon thin film transistors are connected in parallel, the number of the ESD leakage path of the ESD protection will be increased.

In this embodiment, the ESD protection circuit 130 has two pairs of amorphous silicon thin film transistors which are connected in series. When the voltage across the first wiring terminal 131 and the second wiring terminal 132 of the ESD protection circuit 130 is smaller than two times of the threshold voltage of the TFT, only a small amount of current will flow through the TFT due to the high resistance of the ESD protection circuit 130. On the contrary, when the voltage across the first wiring terminal 131 and the second wiring terminal 132 of the ESD protection circuit 130 is larger than two times of the threshold voltage of the TFT, the first amorphous silicon thin film transistor 140 and the second amorphous silicon thin film transistor will be switched on due to the low resistance of the ESD protection circuit 130. In this case, a large amount of current will flow into the ESD leakage bus 120 in a short time, and because the ESD leakage bus 120 may be grounded or connected to a first fixed potential, the current may be conducted away.

In order to prevent the visible light from radiating to the channels of the first amorphous silicon thin film transistor 140 and the second amorphous silicon thin film transistor 150 of the ESD protection circuit 130 and result in the generation of the photocurrent in the ESD protection circuit 130, a first shading layer 146 may be provided over the channels of the first amorphous silicon thin film transistor 140 and the second amorphous silicon thin film transistor 150. The first shading layer 146 is formed of material with lower light transmittance, such as metal, inorganic thin film or organic thin film (including opaque ceramic or metal oxide), and the first shading layer 146 may be formed of conductive material or non-conductive material. The implementations in which the first shading layer is formed of conductive material do not fall within the scope of the present invention, as defined by claim 1. In order to ensure that the visible light can not radiate to the channels of the first amorphous silicon thin film transistor 140 and the second amorphous silicon thin film transistor 150, the area of the first shading layer 146 should is greater than or equal to that of the channel of the first amorphous silicon thin film transistor 140 and that of the channel of the second amorphous silicon thin film transistor 150.

If the first shading layer 146 provided over the channels of the first amorphous silicon thin film transistor 140 and the second amorphous silicon thin film transistor 150 is electrically floating, some uncontrolled effects may be introduced to the ESD protection system and the circuit for which the ESD protection is to be provided, so that the electrical properties of the ESD protection system and the circuit for which the ESD protection is to be provided may be affected. For example, the electrically floating first shading layer 146 may affect the properties of the circuit, such as RC delay property and capacitive coupling property. Further, the electrically floating first shading layer 146 may result in an unstable potential of the circuit, which will result in that the channel of the amorphous silicon thin film transistor under the first shading layer 146 can not be switched on or off normally, so that the ESD protection system can not work normally. In view of this, it is proposed to connect the first shading layer 146 to a second fixed potential 160, for preventing the above defects from occurring.

Particularly, the connection of the first shading layer 146 to a second fixed potential 160 includes: connecting the first shading layer 146 to the second fixed potential 160 directly or connecting the first shading layer 146 to other conductive structure which is connected to the second fixed potential 160, if the first shading layer 146 is formed of conductive material; and connecting the first shading layer 146 to other conductive structure which is connected to the second fixed potential 160, if the first shading layer 146 is formed of nonconductive material.

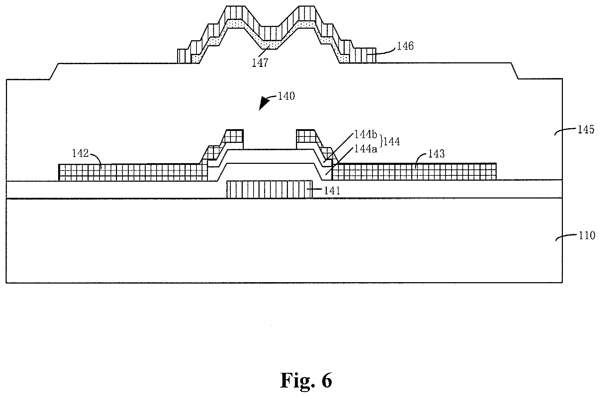

Figure 6 is a sectional view of a first amorphous silicon thin film transistor in an embodiment of the first amorphous silicon thin film transistor of the ESD protection system in Figure 5. As shown in Figure 6, the first amorphous silicon thin film transistor 140 is formed on the substrate 110, which includes the gate 141, an active layer 144 provided above the gate 141, and the source 142 and the drain 143 provided above the active layer 144. The gate 141 may be formed of metal material, such as Ti, Al or Mo. The active layer 144 includes an a-Si layer 144a and a N⁺ a-Si layer 144b provided on the a-Si layer 144a. The source 142 and the drain 143 may be formed of metal material, such as Al or Mo. An insulating layer 145 formed of such as SiNₓ or SiOₓ, is provided above the first amorphous silicon thin film transistor 140. A first shading layer 146 is formed above the insulating layer 145, and is provided over the channel of the first amorphous silicon thin film transistor 140. In order that the first shading layer 146 can prevent the visible light from radiating to the channel of the first amorphous silicon thin film transistor 140, the area of the first shading layer 146 should be greater than or equal to that of the channel of the first amorphous silicon thin film transistor 140. It is to be noted that the second amorphous silicon thin film transistor 150 in the ESD protection circuit 130 has the same as that of the first amorphous silicon thin film transistor 140 in Figure 6, as shown in Figure 5, which will not be described in detail here.

As shown in Figure 5 and Figure 6, in an example not falling within the scope of the present invention, the first shading layer 146 provided over the channel of the first amorphous silicon thin film transistor 140 and the channel of the second amorphous silicon thin film transistor 150 is formed of conductive material, and the first shading layer 146 is connected to the second fixed potential 160 directly. In an embodiment, the conductive material includes at least one of Mo, W and Al, and the conductive material may also include other metals. The second fixed potential 160 may be a zero potential, a positive fixed potential or a negative fixed potential; and the second fixed potential 160 may be provided by an external power supply, and may also be provided by a corresponding structure with a fixed potential in the circuit for which the ESD protection is to be provided.

As shown in Figure 5 and Figure 6, in an example not falling within the scope of the present invention, the ESD protection circuit 130 further includes a first conductive layer 147 provided above the channel of the first amorphous silicon thin film transistor 140 and the channel of the second amorphous silicon thin film transistor 150. The first conductive layer 147 may be provided on or under the first shading layer 146 (the first conductive layer 147 is shown as provided under the first shading layer 146), and the first conductive layer 147 is in contact with the first shading layer 146, thus the first conductive layer 147 at least overlaps with a part of the first shading layer 146. In other words, the first conductive layer 147 may be provided over or under the first shading layer 146. In addition, the first conductive layer 147 may also be provided at the upper right or the bottom right of the first shading layer 146 or the upper left or the bottom left of the first shading layer 146. The first shading layer 146 is formed of conductive material, and the first conductive layer 147 is connected to the second fixed potential 160. In an embodiment, the conductive material includes at least one of Mo, W and Al, and the conductive material may also include other metals. The second fixed potential 160 may be a zero potential, a positive fixed potential or a negative fixed potential. The second fixed potential 160 may be provided by an external power supply and may also be provided by a corresponding structure with a fixed potential in the circuit for which the ESD protection is to be provided. In an embodiment, the conductive layer 147 may be formed of Indium Tin Oxide (ITO). In other embodiment, the first conductive layer 147 may be formed of other suitable conductive materials. It is to be noted that the first conductive layer 147 may be formed by using a separate fabricating process, and may also be formed by using the same fabricating process with the corresponding layer in the circuit for which the ESD protection is to be provided. In this way, the fabricating cost of the ESD protection system may be saved, and the fabricating period of the ESD protection system may be reduced.

As shown in Figure 5 and Figure 6, in an embodiment according to the present invention, the ESD protection circuit 130 further includes a first conductive layer 147 provided above the channel of the first amorphous silicon thin film transistor 140 and the channel of the second amorphous silicon thin film transistor 150. The first conductive layer 147 may be provided on or under the first shading layer 146 (the first conductive layer 147 is shown as provided under the first shading layer 146) and the first conductive layer 147 is in contact with the first shading layer 146. Thus, the first conductive layer 147 at least overlaps with a part of the first shading layer 146. In other words, the first conductive layer 147 may be provided over or under the first shading layer 146, and the first conductive layer 147 may also be provided at the upper right or the bottom right of the first shading layer 146 or the upper left or the bottom left of the first shading layer 146. The first shading layer 146 is formed of nonconductive material, and the first conductive layer 147 is connected to the second fixed potential 160. The second fixed potential 160 may be a zero potential, a positive fixed potential or a negative fixed potential. The second fixed potential 160 may be provided by an external power supply and may also be provided by a corresponding structure with a fixed potential in the circuit for which the ESD protection is to be provided. In an embodiment, the conductive layer 147 may be formed of ITO. In other embodiment, the first conductive layer 147 may be formed of other suitable conductive materials. It is to be noted that the first conductive layer 147 may be formed by using a separate fabricating process, and may also be formed by using the same fabricating process with the corresponding layer in the circuit for which the ESD protection is to be provided. In this way, the fabricating cost of the ESD protection system may be saved, and the fabricating period of the ESD protection system may be reduced.

After the first shading layer 146 is provided over the channel of the first amorphous silicon thin film transistor 140 and the channel of the second amorphous silicon thin film transistor 150, no photocurrent will occur in the ESD protection circuit 130 when the ESD protection system is exposed to the visible light. The ESD protection system according to the invention is generally provided at a peripheral region of the circuit for which the ESD protection is to be provided, and the position of the ESD protection system needs to be decided according to the specific structure of the circuit for which the ESD protection is to be provided, and will not affect the normal work of the circuit for which the ESD protection is to be provided.

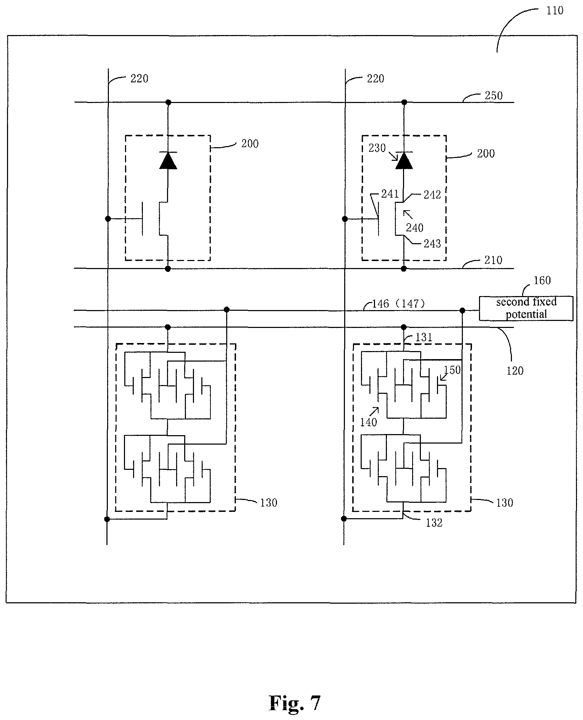

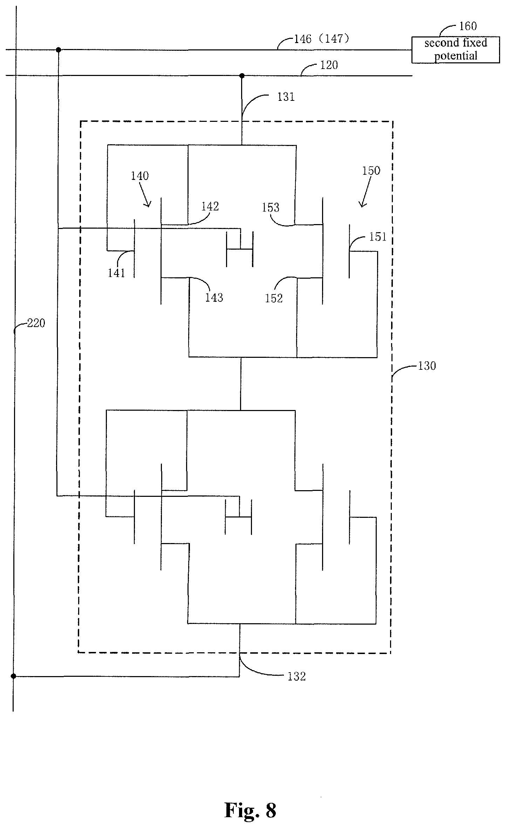

Figure 7 is a schematic diagram of an equivalent circuit of an X-ray flat panel detector in an embodiment of an X-ray flat panel detector with an ESD protection system according to the invention. Figure 8 is an amplified view of the ESD protection circuit connected between the scan line and the ESD leakage bus in Figure 7. As shown in Figure 7 and Figure 8, the X-ray flat panel detector includes multiple (two or more) scan lines (or gate lines) 220 and multiple (two or more) data lines 210 formed on a substrate 110, in which the multiple scan lines 220 and the multiple data lines 210 are arranged in an intersecting manner to form multiple pixel regions, and a pixel unit 200 is provided in each of the pixel regions. The pixel units 200 in the same row are connected by a data line 210, the pixel units 200 in the same column are connected by a scan line 220, and one terminal of each pixel unit 200 is connected to one of the data lines 210 and the other end thereof is connected to one of the scan lines 220. The pixel unit 200 includes a photosensitive unit 230 and a pixel switch 240. One terminal of the photosensitive unit 230 is connected to a second conductive layer 250 which is externally biased, so as to receive a bias signal; and the other terminal thereof is connected to the pixel switch 240. The substrate 110 may be a common semiconductor substrate, and may also be a glass substrate. Only two pixel units 200, one data line 210 and two scan lines 220 are shown in Figure 7. However, it should be understood by those skilled in the art that the X-ray flat panel detector may include N×N pixel units 200, which are respectively provided in the pixel regions formed by the N data lines 210 and N scan lines 220 arranged in an intersecting manner, where N is any integral number greater than 0. The second conductive layer 250 needs to be formed of transparent conductive material. In an embodiment, the transparent conductive material may be ITO.

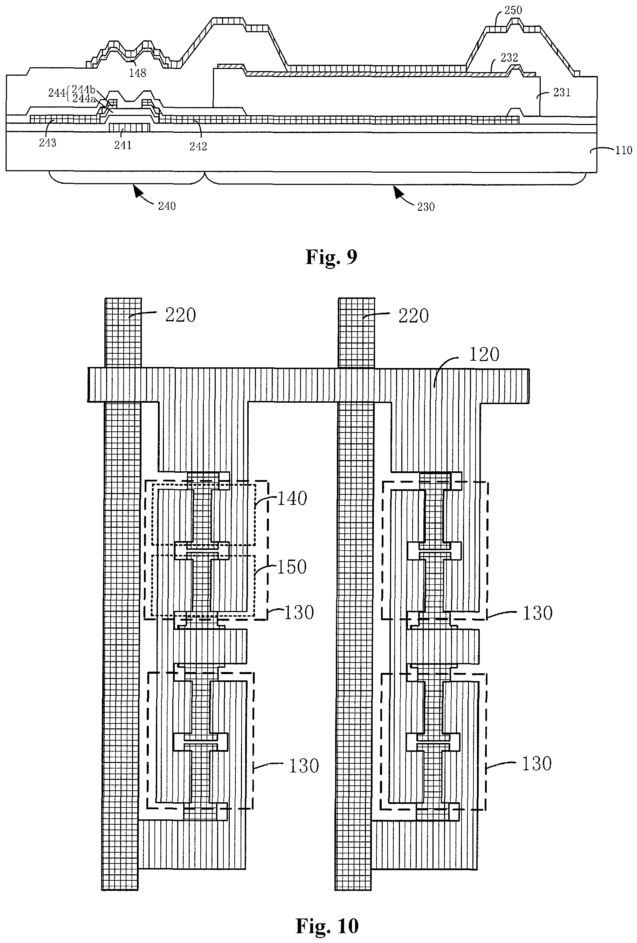

Figure 9 is a sectional view of a pixel unit in an embodiment of an X-ray flat panel detector according to the invention. In this embodiment, the photosensitive unit 230 is a photodiode, and the pixel unit 240 is an amorphous silicon thin film transistor (a-Si TFT). The pixel switch 240 includes the gate 241 formed on a substrate 110, an active layer 244 provided above the gate 241, and the source 242 and the drain 243 provided above the active layer 244. The gate 241 may be formed of metal material, such as Ti, Al or Mo, the active layer 244 includes an a-Si layer 244a and an N⁺ a-Si layer 244b provided above the a-Si layer 244a, and the source 242 and the drain 243 may be formed of metal material, such as Al or Mo. The source 242 of the pixel switch 240 extends to the region in which the photosensitive unit 230 is located, which serves as a lower electrode of the photosensitive unit 230. A PIN-typed photoelectric conversion layer 231 is formed on the source 242 located on the region of the photosensitive unit 230. The PIN-typed photoelectric conversion layer 231 includes a P⁺ a-Si layer, an I a-Si layer and an N⁺ a-Si layer in this order from bottom to top. An upper electrode 232 is formed on the PIN-typed photoelectric conversion layer 231, and the upper electrode 232 is connected to the second conductive layer 250 which is externally biased, for always applying a negative fixed potential to the second conductive layer 250 when the X-ray flat panel detector is driven to work, so as to enable the photosensitive unit 230.

Practically, the photosensitive unit 230 is not limited to the photodiode, and may also be other forms of photosensitive units; and the pixel switch 240 is not limited to the amorphous silicon thin film transistor, and may also be other forms of switch elements.

As shown in Figure 7 and Figure 8, the X-ray flat panel detector further includes the ESD protection system mentioned in either of the above embodiments. The ESD protection system includes an ESD leakage bus 120 and an ESD protection circuit 130. In the case that the ESD protection system is applied to the X-ray flat panel detector, the number of the ESD protection circuit 130 may be one or more. The ESD protection circuit 130 has a first wiring terminal 131 connected to the ESD leakage bus 120 and a second wiring terminal 132 connected to a scan line 220. The X-ray flat panel detector normally includes two or more scan lines 220. Preferably, each scan line 220 in the X-ray flat panel detector is connected to an ESD protection circuit 130. In other words, in the X-ray flat panel detector, the number of the ESD protection circuit 130 is equal to that of the scan line 220.

Figure 10 is a structural diagram of an arrangement in which the first amorphous silicon thin film transistor and the second amorphous silicon thin film transistor are connected between the ESD leakage bus and the scan line. As shown in Figure 8 and Figure 10, the ESD protection circuit 130 includes at least a pair of amorphous silicon thin film transistors. The pair of amorphous silicon thin film transistors includes a first amorphous silicon thin film transistor 140 and a second amorphous silicon thin film transistor 150 connected in a back-to-back manner. Specifically, the gate 141 and the source 142 of the first amorphous silicon thin film transistor 140 and the drain 153 of the second amorphous silicon thin film transistor 150 are connected to the ESD leakage bus 120, and the drain 143 of the first amorphous silicon thin film transistor 140 and the gate 151 and the source 152 of the second amorphous silicon thin film transistor 150 are connected to the scan line 220. The source 142 and the drain 143 of the first amorphous silicon thin film transistor 140, the source 152 and the drain 153 of the second amorphous silicon thin film transistor 150, and the ESD leakage bus 120 may be made of the same layer of metal (indicated by the same shadow), so as to achieve the connection among the source 142 of the first amorphous silicon thin film transistor 140 and the drain 153 of the second amorphous silicon thin film transistor 150 and the ESD leakage bus 120. The scan line 220, the gate 141 of the first amorphous silicon thin film transistor 140 and the gate 151 of the second amorphous silicon thin film transistor 150 may be made of the same layer of metal (indicated by the same shadow).

In this embodiment, the ESD protection circuit 130 has two pairs of amorphous silicon thin film transistors connected in series. In the X-ray flat panel detector, when ESD occurs on the scan line 220 and thus leads to a voltage between the first wiring terminal 131 and the second wiring terminal 132 of the ESD protection circuit 130 which is larger than two times of the threshold voltage of the TFT, the first amorphous silicon thin film transistor 140 and the second amorphous silicon thin film transistor 150 in the ESD protection circuit 130 will be switched on automatically, so that the ESD will flow quickly from the scan line 220 to the ESD leakage bus 120. In this way, a part of the detector is prevented from being broken-down by the ESD voltage or from generating TFT threshold voltage drift or other damages.

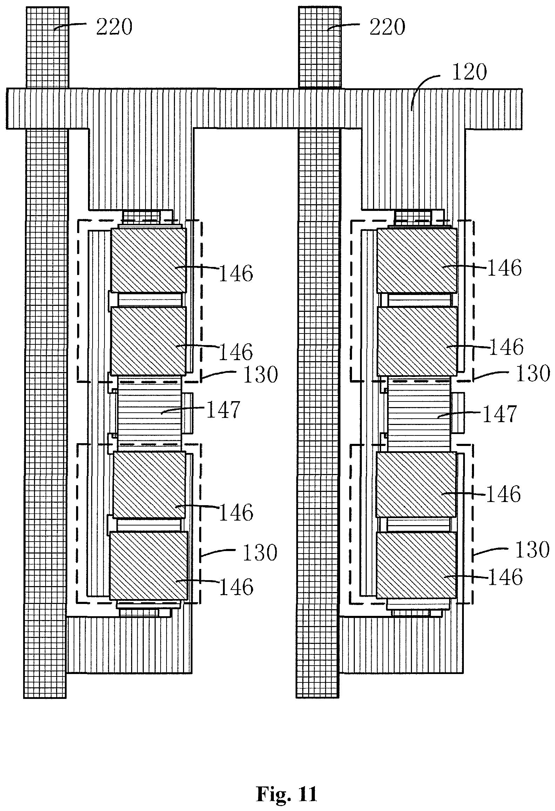

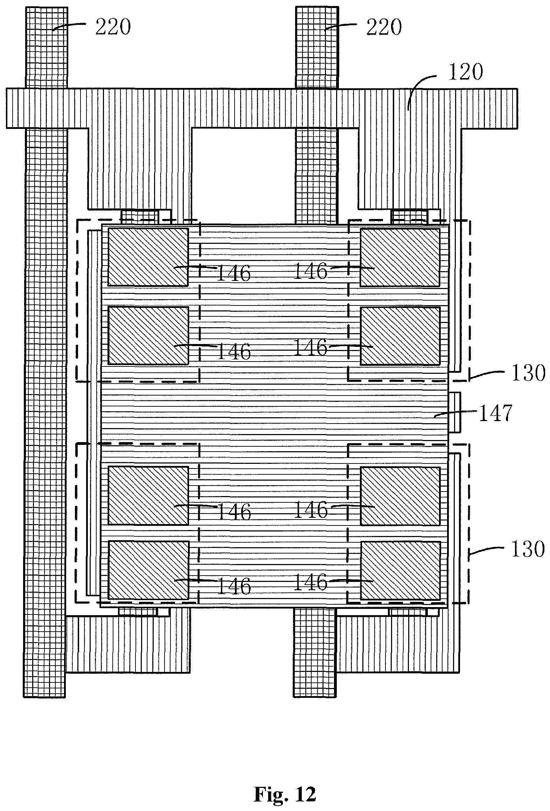

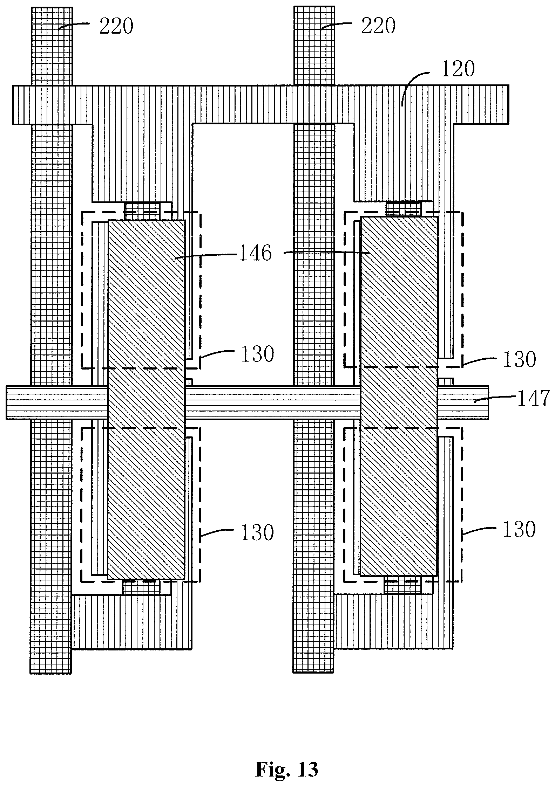

Figure 11 is a first structural diagram of the arrangement in Figure 10 in which a first shading layer and a first conductive layer are provided above the channel of the first amorphous silicon thin film transistor and the channel of the second amorphous silicon thin film transistor. Figure 12 is a second structural diagram of the arrangement in Figure 10 in which a first shading layer and a first conductive layer are provided above the channel of the first amorphous silicon thin film transistor and the channel of the second amorphous silicon thin film transistor. Figure 13 is a third structural diagram of the arrangement in Figure 10 in which a first shading layer and a first conductive layer are provided above the channel of the first amorphous silicon thin film transistor and the channel of the second amorphous silicon thin film transistor. As shown in Figure 10, Figure 11, Figure 12 and Figure 13, in order to prevent the visible light from radiating to the channels of the first amorphous silicon thin film transistor 140 and the second amorphous silicon thin film transistor 150 of the ESD protection circuit 130 during the use of the X-ray flat panel detector, so as to generate the photocurrent in the ESD protection circuit 130, a first shading layer 146 may be provided in the ESD protection system, and the first shading layer 146 is provided over the channel of the first amorphous silicon thin film transistor 140 and the channel of the second amorphous silicon thin film transistor 150. In an embodiment, in the ESD protection circuit 130, the first shading layer 146 provided over the channel of the first amorphous silicon thin film transistor 140 is separated from the first shading layer 146 provided over the channel of the second amorphous silicon thin film transistor 150 (as shown in Figure 11 and Figure 12). In another embodiment, in the ESD protection circuit 130, the first shading layer 146 provided over the channel of the first amorphous silicon thin film transistor 140 is connected to the first shading layer 146 provided over the channel of the second amorphous silicon thin film transistor 150 as a whole (as shown in Figure 13). In the case that the ESD protection circuit 130 includes multiple pairs (which is two pairs in the Figure for example) of amorphous silicon thin film transistors (including the first amorphous silicon thin film transistor 140 and the second amorphous silicon thin film transistor 150), the first shading layers 146 provided over the multiple pairs of amorphous silicon thin film transistors are connected as a whole (as shown in Figure 13). In other embodiments, all the first shading layers 146 of the ESD protection circuits 130 in the ESD protection system may be connected as a whole (not shown), for simplifying the fabricating process of the first shading layer 146.

After the first shading layer 146 is provided over the channel of the first amorphous silicon thin film transistor 140 and the channel of the second amorphous silicon thin film transistor 150 in the ESD protection circuit 130, no photocurrent will occur in the ESD protection circuit 130 during the use of the X-ray flat panel detector, the voltage of the scan line of the X-ray flat panel detector will not be affected, and thus the fluctuation of the electronic image, the noise and the waste of the driving power consumption are reduced.

As shown in Figure 7 and Figure 8, if the first shading layer 146 provided over the channel of the first amorphous silicon thin film transistor 140 and the channel of the second amorphous silicon thin film transistor 150 is electrically floating, some uncontrolled effects is introduced to the ESD protection system and the X-ray flat panel detector, so that the electrical properties of the ESD protection system and the X-ray flat panel detector may be affected. In view of this, the first shading layer 146 may be connected to a second fixed potential 160, for preventing the above defects from occurring.

As described above, and as shown in Figure 5, Figure 7 and Figure 8, the connection of the first shading layer 146 to a second fixed potential 160 includes: connecting the first shading layer 146 to the second fixed potential 160 directly, or connecting the first shading layer 146 to other conductive structure which is connected to the second fixed potential 160, if the first shading layer 146 is formed of conductive material; and connecting the first shading layer 146 to other conductive structure which is connected to the second fixed potential 160, if the first shading layer 146 is formed of nonconductive material. Thus, in the case that the first conductive layer 147 in contact with the first shading layer 146 is provided in the ESD protection circuit 130, if the first shading layer 146 may be made of conductive material, the first conductive layer 147 is connected to the second fixed potential 160; or if the first shading layer 146 may be formed of nonconductive material, the first conductive layer 147 is connected to the second fixed potential 160. In the case that no first conductive layer 147 is provided in the ESD protection circuit 130, if the first shading layer 146 is made of conductive material, the first shading layer 146 is connected to the second fixed potential 160 directly.

As shown in Figure 8, Figure 11, Figure 12 and Figure 13, if a first conductive layer 147 is provided in the ESD protection circuit 130, all the first shading layers 146 of the ESD protection circuits 130 connected onto the same scan line 220 may be connected by the first conductive layer 147, which are led out to the second fixed potential 160. In the circuit with this structure, the first conductive layer 147 of one ESD protection circuit 130 is separated from the first conductive layer 147 of another ESD protection circuit 130 (as shown in Figure 11). In an embodiment, as shown in Figure 12 and Figure 13, all the first conductive layers 147 of the ESD protection circuits 130 may be fabricated by a conductive layer for one time, and then the conductive layer is connected to the second fixed potential 160. In other words, all the first conductive layers 147 of the ESD protection circuits 130 are connected as a whole. In an embodiment, as shown in Figure 13, in the ESD protection circuit 130, the first shading layer 146 provided over the channel of the first amorphous silicon thin film transistor 140 may be connected to the first shading layer 146 provided over the channel of the second amorphous silicon thin film transistor 150 as a whole; and the first conductive layer 147 of one ESD protection circuit 130 is connected to the first conductive layer 147 of another ESD protection circuit 130 as a whole. In this way, the first shading layers 146 and the first conductive layers 147 of multiple ESD protection circuits in the ESD protection system may be formed of the same layer of material, and then the fabricating process of the ESD protection system is simplified.

The second fixed potential 160 may be a zero potential, a positive fixed potential or a negative fixed potential. According to the present invention the second fixed potential is a negative fixed potential. The second fixed potential 160 may be provided in many ways, such as by an external power supply, or by a corresponding layer already existing in the X-ray flat panel detector and having a fixed potential.

As shown in Figure 7, if the pixel switch 240 in the X-ray flat panel detector is the amorphous silicon thin film transistor, the amorphous silicon thin film transistors (including the first amorphous silicon thin film transistor 140 and the second amorphous silicon thin film transistor 150) in the ESD protection circuit 130 and the pixel switch 240 of the amorphous silicon thin film transistor are formed in the same fabricating step, and thus the two types of TFTs have the same threshold voltage. In order to ensure that the first amorphous silicon thin film transistor 140 and the second amorphous silicon thin film transistor 150 in the ESD protection circuit 130 may be switched on and release charges under a relatively lower ESD voltage, the amorphous silicon thin film transistors in the ESD protection circuit 130 and the pixel switch 240 of the amorphous silicon thin film transistor generally have a threshold voltage with the range from 1V to 3V. However, when the X-ray flat panel detector is driven to work normally, the voltage applied on the scan line 220 normally ranges from -10V to +25V. Due to the connection of the ESD protection circuit 130 to the scan line, the voltage applied on the TFT of the ESD protection circuit 130 also ranges from -10V to +25V. Then, heavy leakage current will occur in the ESD protection circuit 130, no matter the voltage applied on the scan line 220 is a positive voltage or a negative voltage, which will result in heavy leakage current in the scan line 220, and cause a great waste of driving power consumption.

To solve this problem, the second fixed potential 160 to which the first shading layer 146 is connected is a negative fixed potential. In this way, when the X-ray flat panel detector is driven to work normally, an electric field may be applied to the TFT from the back of the channel of the first amorphous silicon thin film transistor 140 and the channel of the second amorphous silicon thin film transistor 150, and thus the leakage current in the TFT is reduced, and the waste of driving power consumption in the X-ray flat panel detector is reduced.

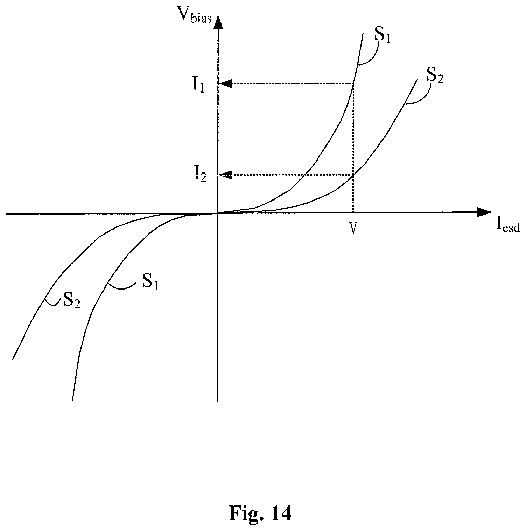

Figure 14 is a graph of relation between an input voltage V_{bias} and a leakage current I_{esd} of the ESD protection circuit, in the case that a first shading layer connected to a negative fixed potential is provided on the ESD protection circuit and a first shading layer connected to a zero potential is provided on the ESD protection circuit respectively. As shown in Figure 14, if a first shading layer connected to a zero potential is provided on the ESD protection circuit, the graph of the relation between the input voltage V_{bias} and the leakage current I_{esd} of the ESD protection circuit is indicated by S₁. When the input voltage V_{bias} is V, the leakage current I_{esd} of the ESD protection circuit is I₁. If a first shading layer connected to a negative fixed potential is provided on the ESD protection circuit, the graph of the relation between the input voltage V_{bias} and the leakage current I_{esd} of the ESD protection circuit is indicated by S₂. When the input voltage V_{bias} is V, the leakage current I_{esd} of the ESD protection circuit is I₂. It can be seen from comparison that I₁>>I₂. Then, if the first shading layer is connected to the negative fixed potential, the leakage current I_{esd} of the ESD protection circuit may be reduced by one order of magnitude, and thus the waste of the driving power consumption is reduced.

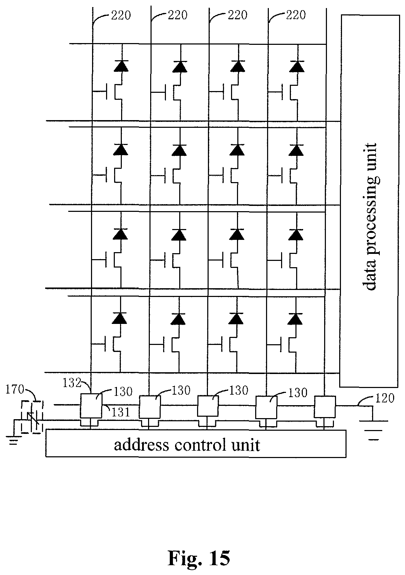

Figure 15 is a schematic diagram of an equivalent circuit for providing a negative fixed potential for the first shading layer of the ESD protection system according to the invention. As shown in Figure 7 and Figure 15, the first wiring terminal 131 of the ESD protection circuit 130 is connected to the ESD leakage bus 120, the second wiring terminal 132 of the ESD protection circuit 130 is connected to the scan line 220, the first shading layer is connected to an external voltage source 170, and a positive terminal of the external voltage source 170 is grounded. Namely, the negative fixed potential may be provided for the first shading layer 146. When the driving voltage of the scan line 220 of the X-ray flat panel detector varies, the amplitude of the external voltage source 170 may be adjusted, so as to set the negative fixed potential to another fixed value, so that the leakage current in the ESD protection circuit 130 may be minimized. The connection of the first shading layer 146 to an external voltage source 170 includes: connecting the first shading layer 146 to the external voltage source 170 directly, or contacting the first shading layer 146 with the first conductive layer 147 which is connected to the external voltage source 170, if the first shading layer 146 is formed of conductive material; and contacting the first shading layer 146 with the first conductive layer 147 which is connected to the external voltage source 170, if the first shading layer 146 is formed of nonconductive material.

As described above, and as shown in Figure 6 and Figure 9, in the case that the pixel unit 200 in the X-ray flat panel detector includes the photodiode 230 and the amorphous silicon thin film transistor 240, a negative fixed potential will be always applied to the second conductive layer 250 when the X-ray flat panel detector is driven to work, so as to enable the photosensitive unit 230. Thus, the first shading layer 146 provided above the ESD protection circuit may be connected to the second conductive layer 250, for providing the negative fixed potential. The connection of the first shading layer 146 to the second conductive layer 250 includes: contacting the first shading layer 146 with the first conductive layer 147 which is connected to the second conductive layer 250. If the first conductive layer 147 is also formed of transparent conductive material (such as ITO), the first conductive layer 147 and the second conductive layer 250 may be formed in the same fabricating step, and are connected as a whole.

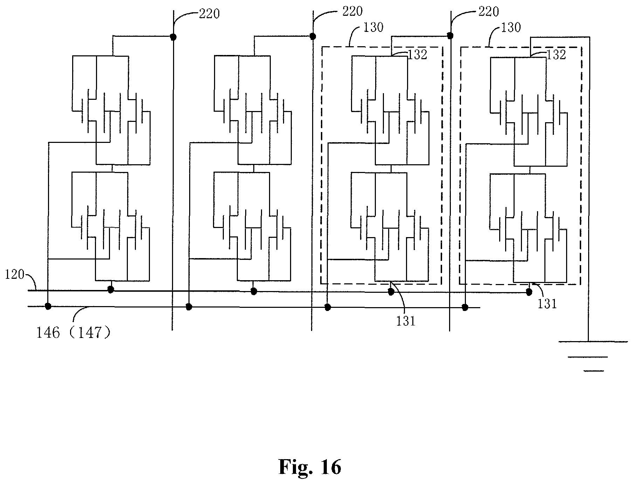

Figure 16 is a schematic diagram of another equivalent circuit for providing a negative fixed potential for the first shading layer of the ESD protection system according to the invention. As shown in Figure 9 and Figure 16, the pixel unit 200 includes the photodiode 230 and the amorphous silicon thin film transistor 240, the scan line 220 is always on the lowest level of -10V or even -20V in most of the time, so as to switch off the pixel switch 240 in the pixel unit 200, and only one scan line 220 is on a high level at a certain time instant. The X-ray flap-panel radiator generally includes thousands of scan lines 220. Other scan lines 220 are on a low level when one scan line 220 is applied with high level. The ESD protection circuit 130 connected to the scan line 220 with high level is operated, and the generated current is distributed to the ESD protection circuits 130 connected to the thousands of scan line 220 with low level, so that the level of the ESD leakage bus 120 is nearly equal to the low level of the scan line 220. Thus, the first shading layer 146 provided above the ESD protection circuit 130 may be connected to the ESD leakage bus 120, for providing the negative fixed potential. The connection of the first shading layer 146 to an ESD leakage bus 120 includes: connecting the first shading layer 146 to the ESD leakage bus 120 directly, or to contacting the first shading layer 146 with the first conductive layer 147 which is connected to the ESD leakage bus 120, if the first shading layer 146 is formed of conductive material; and contacting the first shading layer 146 with the first conductive layer 147 which is connected to the ESD leakage bus 120, if the first shading layer 146 is formed of nonconductive material. As compared with the above manner of providing the negative fixed potential by an external voltage source, the structure of the circuit to a great extent may be simplified in this manner of providing the negative fixed potential.

Referring to Figure 16 again, based on all the embodiments of the X-ray flat panel detector described above, the ESD protection system includes at least two ESD protection circuits according to the invention, for increasing the ESD enduring voltage of the ESD protection system. Four ESD protection circuits are shown in Figure 16 as an example. In this embodiment, a first wiring terminal 131 of one of the ESD protection circuits 130 (the fourth ESD protection circuit 130 in Figure 16) is connected to the ESD leakage bus 120 and a second wiring terminal 132 thereof is grounded. In this embodiment, a first wiring terminal 131 of another of the ESD protection circuits 130 (any one of the first three ESD protection circuits 130 in Figure 16) is connected to the ESD leakage bus 120 and a second wiring terminal 132 thereof is connected to the scan line 220. In other words, in the case that each of the scan lines 220 in the X-ray flat panel detector is connected to the ESD protection circuit 130, the number of the ESD protection circuit 130 is greater than that of the scan line 220 by one.

Referring to Figure 9 again, when the X-ray flat panel detector is driven to work normally, in order to reduce the photocurrent in the pixel switch 240 of the amorphous silicon thin film transistor, a second shading layer 148 may be provided over the channel of the pixel switch 240, so as to prevent the visible light from radiating to the channel of the pixel switch 240. The second shading layer 148 is formed of material with low light transmittance, such as metal, inorganic thin film or organic thin film (including light-tight ceramic or metal oxide). The second shading layer 148 may be formed of conductive material or non-conductive material. In order to prevent the visible light from radiating to the channel of the pixel switch 240 completely, the area of the second shading layer 148 should be greater than or equal to that of the channel of the pixel switch 240. In the case of the electrically floating second shading layer 148, many uncontrolled effects to the X-ray flat panel detector may be introduced. Therefore, the second shading layer 148 may be in contact with the second conductive layer 250 to provide the negative fixed potential for the second shading layer 148. In view of this, the second shading layer 148 at least overlaps with a part of the second conductive layer 250, and the second shading layer 148 may be provided above or under the second conductive layer 250 (the second shading layer 148 is provided under the second conductive layer 250 in Figure 9).

According to the invention, the ESD protection system and the pixel unit of the X-ray flat panel detector may be fabricated on the same substrate. Further, all the parts of the ESD protection system except the shading layer are formed during the existing fabrication process of the X-ray flat panel detector, and thus nearly no new fabrication process is added. In addition, in the case that the ESD protection system is applied to the X-ray flat panel detector, the ESD protection system should be provided at a peripheral region of the X-ray flat panel detector and specifically in the region of the X-ray flat panel detector except the pixel unit region.

In total, comparing with the prior art, the invention has the following advantages.

The ESD protection system according to the invention includes an ESD leakage bus and an ESD protection circuit, the ESD protection circuit has a first wiring terminal connected to the ESD leakage bus and a second wiring terminal, the ESD protection circuit includes at least a pair of amorphous silicon thin film transistors (a-Si TFTs) which includes a first amorphous silicon thin film transistor and a second amorphous silicon thin film transistor connected in a back-to-back manner, and a first shading layer is provided over the channel of the first amorphous silicon thin film transistor and the channel of the second amorphous silicon thin film transistor. In the case that this ESD protection system is applied to an X-ray flat panel detector, ESD protection may be provided for the X-ray flat panel detector, and the photocurrent may be prevented from occurring during the use of the X-ray flat panel detector. Thus, the effect of the photocurrent on the voltage on the scan line is reduced, and the electronic image fluctuation, the noise and the waste of driving power consumption are reduced.

Further, when the first shading layer in the ESD protection system is connected to a fixed potential, it can be ensured that the ESD protection circuit has a relatively small threshold voltage while the leakage current in the ESD protection circuit is restrained, and thus a great waste of driving power consumption in the X-ray flat panel detector is avoided.

Further, all the parts of the ESD protection system except the shading layer are formed during the existing fabrication process of the X-ray flat panel detector, thus nearly no new fabrication process is added.

With the above description of the embodiment, the invention can be better understood, reconstructed and used by those skilled in the art. Apparently, various variations and modifications may be made to the above embodiments by those skilled in the art based on the principle described herein. Therefore, the invention should not be interpreted as limited to the above embodiments described herein, and the scope of protection of the invention should be defined by the appended claims.

## Claims

1. An ESD protection system, comprising:
an ESD leakage bus (120) formed on a substrate; and
an ESD protection circuit (130) formed on the substrate and having a first wiring terminal and a second wiring terminal, wherein the first wiring terminal is connected to the ESD leakage bus, the ESD protection circuit comprises at least a pair of amorphous silicon thin film transistors (140, 150), the pair of amorphous silicon thin film transistors comprises a first amorphous silicon thin film transistor and a second amorphous silicon thin film transistor which are connected in a back-to-back manner, a first shading layer (146) is provided over the channel of the first amorphous silicon thin film transistor and the channel of the second amorphous silicon thin film transistor, a first conductive layer is provided above the channel of the first amorphous silicon thin film transistor and the channel of the second amorphous silicon thin film transistor, and the first conductive layer is contacted with the first shading layer;
wherein the first shading layer is formed of non-conductive material and is used for avoiding photocurrent by preventing light from radiating to the channel of the first amorphous silicon thin film transistor and the channel of the second amorphous silicon thin film transistor, and the first conductive layer is connected to a second fixed potential (160), and the second fixed potential is a negative fixed potential.

2. The ESD protection system according to claim 1, wherein the ESD protection circuit comprises a plurality of pairs of amorphous silicon thin film transistors which are connected in series, in parallel or in series-parallel.

3. The ESD protection system according to claim 1, wherein an area of the first shading layer is greater than or equal to that of the channel of the first amorphous silicon thin film transistor and that of the channel of the second amorphous silicon thin film transistor.

4. The ESD protection system according to claim 1, wherein the ESD leakage bus is grounded or connected to a first fixed potential.

5. The ESD protection system according to claim 1, wherein the first conductive layer is provided above or under the first shading layer and at least overlaps with a part of the first shading layer.

6. The ESD protection system according to claim 5, wherein the second fixed potential is provided by an external power supply (170).

7. An X-ray flat panel detector, comprising:
a plurality of scan lines (220) and a plurality of data lines (210) formed on a substrate, wherein the plurality of scan lines and the plurality of data lines are arranged in an intersecting manner to form a plurality of pixel regions, and a pixel unit (200) comprising a photosensitive unit (230) and a pixel switch (240) is provided in each of the plurality of pixel regions; and
the ESD protection system according to claim 1, wherein the number of the ESD protection circuit in the ESD protection system is one or more, and at least one of the plurality of scan lines is connected to the second wiring terminal of one of the ESD protection circuits.

8. The X-ray flat panel detector according to claim 7, wherein the photosensitive unit is a photodiode, the pixel switch is an amorphous silicon thin film transistor, the photodiode comprises a lower electrode, a photoelectric conversion layer provided on the lower electrode and an upper electrode provided on the photoelectric conversion layer, the lower electrode of the photodiode is connected to the pixel switch, the upper electrode of the photodiode is connected to a second conductive layer which is externally biased, and the pixel switch comprises the source connected to the lower electrode of the photosensitive unit, the drain connected to one of the data lines and the gate connected to one of the scan lines.

9. The X-ray flat panel detector according to claim 8, wherein a second shading layer is provided over the channel of the pixel switch.

10. The X-ray flat panel detector according to claim 9, wherein the second shading layer at least overlaps with a part of the second conductive layer and is contacted with the second conductive layer, and the second shading layer is provided above or under the second conductive layer.

11. The X-ray flat panel detector according to claim 7, wherein the number of the ESD protection circuit in the ESD protection system is two or more, the first wiring terminal of one of the ESD protection circuits is connected to the ESD leakage bus, and the second wiring terminal of the one of the ESD protection circuits is connected to one of the plurality of scan lines, and wherein the first wiring terminal of another of the ESD protection circuits is connected to the ESD leakage bus, and the second wiring terminal of the another of the ESD protection circuits is grounded.

12. An X-ray flat panel detector, comprising:
a plurality of scan lines (220) and a plurality of data lines (210) formed on a substrate, wherein the plurality of scan lines and the plurality of data lines are arranged in an intersecting manner to form a plurality of pixel regions, a pixel unit (200) comprising a photosensitive unit (230) and a pixel switch (240) is provided in each of plurality of the pixel regions, the photosensitive unit is a photodiode, the pixel switch is an amorphous silicon thin film transistor, the photodiode comprises a lower electrode, a photoelectric conversion layer provided on the lower electrode and an upper electrode provided on the photoelectric conversion layer, the lower electrode of the photodiode is connected to the pixel switch, the upper electrode of the photodiode is connected to a second conductive layer of which is externally biased, and the pixel switch comprises the source connected to the lower electrode of the photosensitive unit, the drain connected to one of the data lines and the gate connected to one of the scan lines; and
the ESD protection system according to claim 5, wherein the number of the ESD protection circuit is one or more, and at least one of the plurality of scan lines is connected to the second wiring terminal of one of the ESD protection circuits, the second fixed potential is a negative fixed potential, the second conductive layer which is externally biased is connected to the first conductive layer of the ESD protection circuit to provide the second fixed potential, or the ESD leakage bus is connected to the first conductive layer of the ESD protection circuit to provide the second fixed potential.

13. The X-ray flat panel detector according to claim 12, wherein the number of the ESD protection circuit in the ESD protection system is two or more, the first wiring terminal of one of the ESD protection circuits is connected to the ESD leakage bus, and the second wiring terminal of the one of the ESD protection circuits is connected to one of the plurality of scan lines, and wherein the first wiring terminal of another of the ESD protection circuits is connected to the ESD leakage bus, and the second wiring terminal of the another of the ESD protection circuits is grounded, and the ESD leakage bus is connected to the first conductive layer of the ESD protection circuit to provide the second fixed potential.

## Patentansprüche

1. ESD-Schutzsystem, umfassend:
einen auf einem Substrat ausgebildeten ESD-Ableitungsbus (120); und eine ESD-Schutzschaltung (130), die auf dem Substrat ausgebildet ist und einen ersten Verdrahtungsanschluss und einen zweiten Verdrahtungsanschluss aufweist, wobei der erste Verdrahtungsanschluss mit dem ESD-Ableitungsbus verbunden ist, wobei die ESD-Schutzschaltung mindestens ein Paar von Dünnfilmtransistoren (140, 150) aus amorphem Silizium aufweist, das Paar von Dünnfilmtransistoren aus amorphem Silizium einen ersten Dünnfilmtransistor aus amorphem Silizium und einen zweiten Dünnfilmtransistor aus amorphem Silizium aufweist, die Rücken an Rücken miteinander verbunden sind, wobei eine erste Abschattungsschicht (146) über dem Kanal des ersten Dünnschichttransistors aus amorphem Silizium und dem Kanal des zweiten Dünnschichttransistors aus amorphem Silizium vorgesehen ist, eine erste leitende Schicht über dem Kanal des ersten Dünnschichttransistors aus amorphem Silizium und dem Kanal des zweiten Dünnschichttransistors aus amorphem Silizium vorgesehen ist, und die erste leitende Schicht mit der ersten Abschattungsschicht kontaktiert ist;
wobei die erste Abschattungsschicht aus einem nichtleitenden Material gebildet ist und zum Vermeiden eines Photostroms verwendet wird, indem verhindert wird, dass Licht zum Kanal des ersten Dünnfilmtransistors aus amorphem Silizium und zum Kanal des zweiten Dünnfilmtransistors aus amorphem Silizium abgestrahlt wird, und die erste leitende Schicht mit einem zweiten festen Potential (160) verbunden ist, und das zweite feste Potential ein negatives festes Potential ist.

2. ESD-Schutzsystem nach Anspruch 1, wobei die ESD-Schutzschaltung mehrere Paare von Dünnschichttransistoren aus amorphem Silizium aufweist, die seriell, parallel oder seriell - parallel geschaltet sind.

3. ESD-Schutzsystem nach Anspruch 1, wobei eine Fläche der ersten Abschattungsschicht größer oder gleich der des Kanals des ersten Dünnfilmtransistors aus amorphem Silizium und der des Kanals des zweiten Dünnfilmtransistors aus amorphem Silizium ist.

4. ESD-Schutzsystem nach Anspruch 1, wobei der ESD-Ableitungsbus geerdet oder mit einem ersten festen Potential verbunden ist.

5. ESD-Schutzsystem nach Anspruch 1, wobei die erste leitende Schicht über oder unter der ersten Abschattungsschicht vorgesehen ist und sich zumindest mit einem Teil der ersten Abschattungsschicht überlappt.

6. ESD-Schutzsystem nach Anspruch 5, wobei das zweite feste Potential von einer externen Stromversorgung (170) bereitgestellt wird.

7. Röntgenflachdetektor, umfassend:
eine Mehrzahl von Abtastleitungen (220) und eine Mehrzahl von Datenleitungen (210), die auf einem Substrat ausgebildet sind, wobei die Mehrzahl von Abtastleitungen und die Mehrzahl von Datenleitungen in einer sich schneidenden Weise angeordnet angeordnet sind, um eine Mehrzahl von Pixelregionen zu bilden, und eine Pixeleinheit (200) vorgesehen ist, die eine lichtempfindliche Einheit (230) und einen Pixelschalter (240) in jeder der Mehrzahl von Pixelregionen aufweist; und
ESD-Schutzsystem nach Anspruch 1, wobei die Anzahl der ESD-Schutzschaltungen in dem ESD-Schutzsystem eins oder mehr ist, und mindestens eine der Mehrzahl von Abtastleitungen mit dem zweiten Verdrahtungsanschluss einer der ESD Schutzschaltungen verbunden ist.

8. Röntgenflachdetektor nach Anspruch 7, wobei die lichtempfindliche Einheit eine Fotodiode ist, der Pixelschalter ein Dünnfilmtransistor aus amorphem Silizium ist, die Fotodiode eine untere Elektrode, eine fotoelektrische Wandlerschicht, die auf der unteren Elektrode vorgesehen ist, und eine obere Elektrode, die auf der fotoelektrischen Wandlerschicht vorgesehen ist, aufweist, wobei die untere Elektrode der Fotodiode mit dem Pixelschalter verbunden ist, die obere Elektrode der Fotodiode mit einer zweiten leitenden Schicht verbunden ist, die von außen vorgespannt ist, und der Pixelschalter die Source aufweist, die mit der unteren Elektrode der lichtempfindlichen Einheit verbunden ist, den Drain, der mit einer der Datenleitungen verbunden ist, und das Gate, das mit einer der Abtastleitungen verbunden ist.

9. Röntgenflachdetektor nach Anspruch 8, wobei eine zweite Abschattungsschicht über dem Kanal des Pixelschalters vorgesehen ist.

10. Röntgenflachdetektor nach Anspruch 9, wobei die zweite Abschattungsschicht mindestens einen Teil der zweiten leitenden Schicht überlappt und mit der zweiten leitenden Schicht kontaktiert ist und die zweite Abschattungsschicht über oder unter der zweiten leitenden Schicht vorgesehen ist.

11. Röntgenflachdetektor nach Anspruch 7, wobei die Anzahl der ESD-Schutzschaltungen in dem ESD-Schutzsystem zwei oder mehr beträgt, der erste Verdrahtungsanschluss einer der ESD-Schutzschaltungen mit dem ESD-Ableitungsbus verbunden ist und der zweite Verdrahtungsanschluss der einen der ESD-Schutzschaltungen mit einer der Mehrzahl von Abtastleitungen verbunden ist, und wobei der erste Verdrahtungsanschluss einer anderen der ESD-Schutzschaltungen mit dem ESD-Ableitungsbus verbunden ist, und der zweite Verdrahtungsanschluss von einer anderen der ESD-Schutzschaltungen geerdet ist.

12. Röntgenflachdetektor, umfassend:
eine Mehrzahl von Abtastleitungen (220) und eine Mehrzahl von Datenleitungen (210), die auf einem Substrat ausgebildet sind, wobei die Mehrzahl von Abtastleitungen und die Mehrzahl von Datenleitungen in einer sich schneidenden Weise angeordnet sind um eine Mehrzahl von Pixelregionen zu bilden. eine Pixeleinheit (200) mit einer lichtempfindlichen Einheit (230) und einem Pixelschalter (240) in jeder der Mehrzahl von Pixelregionen vorgesehen ist, wobei die lichtempfindliche Einheit eine Fotodiode ist, der Pixelschalter ein Dünnfilmtransistor aus amorphem Silizium ist, die Fotodiode eine untere Elektrode, eine fotoelektrische Wandlerschicht, die auf der unteren Elektrode vorgesehen ist, und eine obere Elektrode, die auf der fotoelektrischen Wandlerschicht vorgesehen ist, aufweist, wobei die untere Elektrode der Fotodiode mit dem Pixelschalter verbunden ist, die obere Elektrode der Fotodiode mit einer zweiten leitenden Schicht verbunden ist, die von außen vorgespannt ist, und der Pixelschalter die Source aufweist, die mit der unteren Elektrode der lichtempfindlichen Einheit verbunden ist, den Drain, der mit einer der Datenleitungen verbunden ist, und das Gate, das mit einer der Abtastleitungen verbunden ist; und
ESD-Schutzsystem nach Anspruch 5, wobei die Anzahl der ESD-Schutzschaltungen eins oder mehr ist und mindestens eine der mehreren Abtastleitungen mit dem zweiten Verdrahtungsanschluss einer der ESD-Schutzschaltungen verbunden ist, das zweite feste Potential ein negatives festes Potential ist, die von außen vorgespannte zweite leitende Schicht mit der ersten leitenden Schicht der ESD-Schutzschaltung verbunden ist, um das zweite feste Potential bereitzustellen, oder der ESD-Ableitungsbus mit der ersten leitenden Schicht der ESD-Schutzschaltung verbunden ist, um das zweite feste Potential bereitzustellen.

13. Röntgenflachdetektor nach Anspruch 12, wobei die Anzahl der ESD-Schutzschaltungen in dem ESD-Schutzsystem zwei oder mehr beträgt, der erste Verdrahtungsanschluss einer der ESD-Schutzschaltungen mit dem ESD-Ableitungsbus verbunden ist und der zweite Verdrahtungsanschluss der einen der ESD-Schutzschaltungen mit einer der Mehrzahl von Abtastleitungen verbunden ist, und wobei der erste Verdrahtungsanschluss einer anderen der ESD-Schutzschaltungen mit dem ESD-Ableitungsbus verbunden ist, und der zweite Verdrahtungsanschluss einer der anderen ESD-Schutzschaltungen geerdet ist, und der ESD-Ableitungsbus mit der ersten leitenden Schicht der ESD-Schutzschaltung verbunden ist, um das zweite feste Potential bereitzustellen.

## Revendications

1. Un système de protection ESD, comprenant :
un bus de fuite ESD (120) formé sur un substrat ; et
un circuit de protection ESD (130) formé sur le substrat et ayant une première borne de câblage et une deuxième borne de câblage, la première borne de câblage étant connectée au bus de fuite ESD, le circuit de protection ESD comprend au moins une paire de transistors à couche mince (140, 150) en silicium amorphe, la paire de transistors à couche mince en silicium amorphe comprenant un premier transistor à couche mince en silicium amorphe et un deuxième transistor à couche mince en silicium amorphe qui sont connectés d'une manière dos-à-dos, une première couche d'ombrage (146) étant prévue sur le canal du premier transistor à couche mince en silicium amorphe et sur le canal du deuxième transistor à couche mince en silicium amorphe, une première couche conductrice étant prévue au-dessus du canal du premier transistor à couche mince en silicium amorphe et du canal du deuxième transistor à couche mince en silicium amorphe, et la première couche conductrice est en contact avec la première couche d'ombrage ;
la première couche d'ombrage étant formée en un matériau non conducteur et étant utilisée pour éviter le photocourant en empêchant la lumière de rayonner vers le canal du premier transistor à couche mince en silicium amorphe et vers le canal du deuxième transistor à couche mince en silicium amorphe, et la première couche conductrice étant connectée à un deuxième potentiel fixe (160), le deuxième potentiel fixe étant un potentiel fixe négatif.

2. Le système de protection ESD selon la revendication 1, dans lequel le circuit de protection ESD comprend une pluralité de paires de transistors à couche mince en silicium amorphe qui sont connectés en série, en parallèle ou en série parallèle.

3. Le système de protection ESD selon la revendication 1, dans lequel une zone de la première couche d'ombrage est supérieure ou égale à celle du canal du premier transistor à couche mince en silicium amorphe et celle du canal du deuxième transistor à couche mince en silicium amorphe.

4. Le système de protection ESD selon la revendication 1, dans lequel le bus de fuite ESD est mis à la terre ou est relié à un premier potentiel fixe.

5. Le système de protection ESD selon la revendication 1, dans lequel la première couche conductrice est prévue au-dessus ou au-dessous de la première couche d'ombrage et recouvre au moins une partie de la première couche d'ombrage.

6. Le système de protection ESD selon la revendication 5, dans lequel le deuxième potentiel fixe est fourni par une alimentation électrique externe (170).

7. Un détecteur de rayons X à panneau plat, comprenant :
une pluralité de lignes de balayage (220) et une pluralité de lignes de données (210) formées sur un substrat, dans lequel la pluralité de lignes de balayage et la pluralité de lignes de données sont agencées de manière à se croiser pour former une pluralité de zones de pixels, et une unité de pixels (200) comprenant une unité photosensible (230) et un commutateur de pixels (240) étant prévu dans chacune de la pluralité des zones de pixels ; et
le système de protection ESD selon la revendication 1, dans lequel le nombre de circuits de protection ESD dans le système de protection ESD est de un ou plus de un, et au moins une ligne de balayage faisant partie de la pluralité de lignes de balayage est connectée à la deuxième borne de câblage de l'un des circuits de protection ESD.

8. Le détecteur de rayons X à panneau plat selon la revendication 7, dans lequel l'unité photosensible est une photodiode, le commutateur de pixels est un transistor à couche mince en silicium amorphe, la photodiode comprend une électrode inférieure, une couche de conversion photoélectrique étant prévue sur l'électrode inférieure et une électrode supérieure étant prévue sur la couche de conversion photoélectrique, l'électrode inférieure de la photodiode est connectée au commutateur de pixels, l'électrode supérieure de la photodiode est connectée à une deuxième couche conductrice qui est polarisée extérieurement, et le commutateur de pixels comprend la source connectée à l'électrode inférieure de l'unité photosensible, le drain étant connecté à une des lignes de données et la grille étant connectée à une des lignes de balayage.

9. Le détecteur de rayons X à panneau plat selon la revendication 8, dans lequel une deuxième couche d'ombrage est prévue sur le canal du commutateur de pixels.

10. Le détecteur de rayons X à panneau plat selon la revendication 9, dans lequel la deuxième couche d'ombrage recouvre au moins une partie de la deuxième couche conductrice et est en contact avec la deuxième couche conductrice, et la deuxième couche d'ombrage est prévue au-dessus ou au-dessous de la deuxième couche conductrice.

11. Le détecteur de rayons X à panneau plat selon la revendication 7, dans lequel le nombre du circuit de protection ESD dans le système de protection ESD est de deux ou plus, la première borne de câblage de l'un des circuits de protection ESD est connectée au bus de fuite ESD, et la deuxième borne de câblage de l'un des circuits de protection ESD est connectée à une ligne parmi la pluralité des lignes de balayage, et dans lequel la première borne de câblage d'un autre des circuits de protection ESD est connectée au bus de fuite ESD, et la deuxième borne de câblage de ladite autre des circuits de protection ESD est mise à la terre.

12. Un détecteur de rayons X à panneau plat, comprenant :
une pluralité de lignes de balayage (220) et une pluralité de lignes de données (210) formées sur un substrat, la pluralité de lignes de balayage et la pluralité de lignes de données étant disposées de manière à se croiser pour former une pluralité de zones de pixels, une unité de pixels (200) comprenant une unité photosensible (230) et un commutateur de pixels (240) étant prévu dans chacune des zones de pixels, l'unité photosensible étant une photodiode, le commutateur de pixels étant un transistor en couche mince en silicium amorphe, la photodiode comportant une électrode inférieure, une couche de conversion photoélectrique étant prévue sur l'électrode inférieure et une électrode supérieure étant prévue sur la couche de conversion photoélectrique, l'électrode inférieure de la photodiode étant connectée au commutateur de pixels, l'électrode supérieure de la photodiode étant connectée à une deuxième couche conductrice dont la polarisation est externe, et le commutateur de pixels comprenant la source connectée à l'électrode inférieure de l'unité photosensible, le drain étant connecté à une des lignes de données et la grille étant connectée à une des lignes de balayage ; et
le système de protection ESD selon la revendication 5, dans lequel le nombre du circuit de protection ESD est de un ou plus de un, et au moins une ligne de balayage faisant partie de la pluralité de lignes de balayage est connectée à la deuxième borne de câblage de l'un des circuits de protection ESD, le deuxième potentiel fixe étant un potentiel fixe négatif, la deuxième couche conductrice qui est polarisée extérieurement étant connectée à la première couche conductrice du circuit de protection ESD pour fournir le deuxième potentiel fixe, ou le bus de fuite ESD étant connecté à la première couche conductrice du circuit de protection ESD pour fournir le deuxième potentiel fixe.

13. Le détecteur de rayons X à panneau plat selon la revendication 12, dans lequel le nombre du circuit de protection ESD dans le système de protection ESD est de deux ou plus de deux, la première borne de câblage de l'un des circuits de protection ESD est connectée au bus de fuite ESD, et la deuxième borne de câblage de l'un des circuits de protection ESD est connectée à une ligne de balayage faisant partie de la pluralité de lignes de balayage, et dans lequel la première borne de câblage d'un autre des circuits de protection ESD est connectée au bus de fuite ESD, et la deuxième borne de câblage dudit autre circuit de protection ESD est mise à la terre, et le bus de fuite ESD est connecté à la première couche conductrice du circuit de protection ESD pour fournir le deuxième potentiel fixe.
